# EUROPÄISCHE PATENTSCHRIFT

(11) **EP 1 303 880 B1**
(45) Veröffentlichungstag und Bekanntmachung des Hinweises auf die Patenterteilung: **25.01.2012**
(21) Anmeldenummer: 01955336.1
(22) Anmeldetag: 06.07.2001
(51) Int. Cl.: H01L 23/544

(54) **VERFAHREN ZUM AUFBRINGEN VON JUSTIERMARKEN AUF EINER HALBLEITERSCHEIBE**
METHOD FOR APPLYING ADJUSTMENT MARKS ON A SEMICONDUCTOR DISK
PROCEDE D'APPLICATION DE REPERES DE REGLAGE SUR UNE PLAQUETTE SEMI-CONDUCTRICE

(30) Priorität: 26.07.2000 DE 10037446
(43) Veröffentlichungstag der Anmeldung: 23.04.2003
(73) Patentinhaber: Infineon Technologies AG, 85579 Neubiberg (DE)
(72) Erfinder: DIEWALD, Wolfgang, A-9500 Villach (AT); MÜMMLER, Klaus, 91058 Erlangen (DE)
(74) Vertreter: Barth, Stephan Manuel
(86) Internationale Anmeldenummer: PCT/EP2001/007782
(87) Internationale Veröffentlichungsnummer: WO 2002/009176

(56) Entgegenhaltungen:
- WO-A-00/35627
- US-A- 5 858 854
- US-A- 5 874 778
- US-A- 5 904 563
- US-A- 6 051 496
- GOTKIS ET AL: "Cu CMP with orbital technology: summary of the experience" , ADVANCED SEMICONDUCTOR MANUFACTURING CONFERENCE AND WORKSHOP, 1998. 1998 IEEE/SEMI BOSTON, MA, USA 23-25 SEPT. 1998, NEW YORK, NY, USA,IEEE, US, PAGE(S) 364-371 XP010314156 ISBN: 0-7803-4380-8 das ganze Dokument
- MOUSSAVI ET AL: "Comparison of barrier materials and deposition processes for copper integration" , INTERCONNECT TECHNOLOGY CONFERENCE, 1998. PROCEEDINGS OF THE IEEE 1998 INTERNATIONAL SAN FRANCISCO, CA, USA 1-3 JUNE 1998, NEW YORK, NY, USA,IEEE, US, PAGE(S) 295-297 XP010295546 ISBN: 0-7803-4285-2 das ganze Dokument
- PATENT ABSTRACTS OF JAPAN vol. 2000, no. 11, 3. Januar 2001 (2001-01-03) -& JP 2000 232154 A (SONY CORP), 22. August 2000 (2000-08-22)

## Beschreibung

Die Erfindung betrifft ein Verfahren zum Aufbringen von Justiermarken auf einer Halbleiterscheibe.

Aus der US-A-5,786,260 ist ein Verfahren zum Aufbringen von Justiermarken auf einer Halbleiterscheibe bekannt, bei dem Vertiefungen in einem Oberflächenbereich der Halbleiterscheibe ausgebildet werden, wobei sich Stege zwischen den Vertiefungen bilden, anschließend eine Zwischenschicht und dann eine isolierende Schicht oder auch eine Metallschicht aufgebracht werden. Bei einem anschließenden CMP-Prozess wird die isolierende Schicht bzw. die Metallschicht unter Ausnutzung des Dishing-Verhaltens so entfernt, dass die Kanten der Justiermarken freigelegt werden und sich abheben. Ein nachfolgender Ätzschritt zur restlosen Beseitigung der isolierenden Schicht bzw. Metallschicht in den Vertiefungen ist als optional angegeben.

Aus der US-A-6,051,496 ist die Verwendung einer Stoppschicht beim CMP-Prozess bekannt, welche auf einer Dielektrikumsschicht mit Stegen und Vertiefungen abgeschieden wird, und zwar insbesondere beim CU-Damascene.

Die US-A-6,080,636 offenbart einen Herstellungsprozess für eine photolithographische Justiermarke durch einen CMP-Prozess.

Die US-A-6,020,263 offenbart ein Verfahren zum Freilegen von Justiermarken nach einem CMP-Prozess auf Wolframmetall.

Die Strukturierung von Halbleiterscheiben zum Herstellen mikroelektrischer Bauelemente erfolgt heute fast durchweg mit Hilfe lithographischer Techniken. Die Strukturen werden dabei zunächst über eine Photomaske in einer dünnen strahlungsempfindlichen Resist-Schicht, meist einer organischen Photolackschicht, die auf der Halbleiterscheibe aufgebracht ist, erzeugt. Durch einen geeigneten Entwickler werden dann die bestrahlten oder unbestrahlten Bereiche entfernt. Das so entstehende Resist-Muster dient als Maske für einen darauffolgenden Prozessschritt, z. B. einer Ätzung oder einer Ionenimplantation, mit der das Muster in die darunterliegende Halbleiterstrukturschicht übertragen wird. Anschließend wird die Resist-Maske dann wieder abgelöst.

Entscheidend für die Qualität des Lithographieverfahrens ist es dabei, die Resist-Struktur lagerichtig auf die darunterliegende Halbleiterschicht zu übertragen. Hierbei ist es insbesondere erforderlich, das Belichtungsgerät zur Ausbildung der Maskenstruktur in Bezug zur Halbleiterscheibe genau zu justieren. Zum Justieren des Belichtungsgeräts werden deshalb im Allgemeinen Justiermarken auf der Halbleiterscheibe angebracht. Diese Justiermarken sind in der Regel eine aus Balken und Linien bestehende Struktur, die im Allgemeinen im Kerfbereich der Halbleiterscheibe ausgeführt werden. Der Kerfbereich der Halbleiterscheibe stellt einen ca. 50 bis 100 µm breiten Bereich zwischen den einzelnen Chips auf der Halbleiterscheibe dar, der beim abschließenden Zerlegen der Halbleiterscheibe in die einzelnen Chips dann zerstört wird. Der Vorgang der Justierung gestaltet sich aber dann als schwierig, wenn eine zusätzliche, optisch nicht transparent Schicht, die z. B. für die Herstellung eines Kondensators benötigt wird, aufgebracht ist und so die darunterliegende Justiermarkenstruktur in der Halbleiterscheibe optisch nicht erfasst werden kann. In einem solchen Fall erfolgt dann das Aufbringen der Justiermarken auf der Halbleiterscheibe im Stand der Technik so, dass beim Ätzen der vorausgehenden Struktur in die Halbleiterscheibe zugleich die Balken und Linien in den Kerfbereich eingeätzt werden, wobei die Justiermasken so ausgelegt sind, dass diese bei den nachfolgenden Prozessschritten einschließlich der Abscheidung der optisch nicht transparenten Schicht nicht mehr vollständig aufgefüllt werden. Die Topologie der Justiermarken auf der Halbleiterscheibe kann dann mittels lichtoptischer Justiermarken-Erkennungsverfahren erfasst und zur Justierung des Belichtungsgeräts genutzt werden.

Diese Art der Justiermarkenausbildung erweist sich jedoch insbesondere dann als ungeeignet, wenn sie im Rahmen der Damascene-Technik, die im Wesentlichen zur Strukturierung einer Metallisierungsebene verwendet wird, erfolgen soll. Bei der Damascene-Technik, die vor allem zur Kupferstrukturierung eingesetzt wird, werden zur Herstellung der Metallverdrahtung am Ort der Leiterbahnen Vertiefungen in das darunterliegende Oxid geätzt. In diesem Ätzschritt wird dann auch nach dem herkömmlichen Verfahren die Justiermarkenstruktur ausgebildet. Anschließend erfolgt das Aufsputtern bzw. Abscheiden einer dünnen Startschicht zur Keimbildung für die darauffolgende ganzflächige Metalldeposition. Durch chemisch-mechanisches Polieren der Metallschicht bis zur Oberfläche der geätzten Gräben entstehen dann die gewünschten Leiterbahnen. Da im Damascene-Verfahren eine im Wesentlichen perfekte Planarisierung der Metallschicht ausgeführt wird, wird auch die Topologie der Justiermarken beim chemisch-mechanischen Polieren weitgehend eingeebnet, so dass diese sich nach dem Aufbringen eine nachfolgenden, optisch nicht transparenten Schicht nicht mehr abheben. Weiterhin lassen sich, insbesondere beim Kupfer-Damascene-Verfahren die für die Justiermarken geätzten Gräben auch nicht so ausbilden, dass diese sich während der Kupferabscheidung nur unvollständig auffüllen, da Kupfer bei den üblicherweise verwendeten Abscheideverfahren alle Gräben unabhängig von deren Breite immer von unten her anfüllt und sich damit auch keine Voids, d. h. Hohlräume in den Gräben erzeugen lassen, die dann auf einer anschließend abgeschiedenen optisch nicht transparenten Schicht zu einer Topologie der Justiermarken führen.

Um dieses Problem zu lösen, wird deshalb im Stand der Technik auch, insbesondere beim Damascene-Verfahren, eine Topologie der Justiermarken durch einen weiteren Lithographie- und Ätzschritt erzeugt, der selbst nur eine ungenaue Justierung erfordert. Hierzu wird nach dem Herstellen der Justiermarken und dem anschließenden Abscheiden der optisch nicht transparenten Schicht die Justiermaskenstruktur über eine eigene Photomaske auf eine dünne strahlungsempfindliche Schicht übertragen, die auf der optisch nicht transparenten Schicht aufgebracht ist. Mit einem anschließenden Ätzschritt werden dann die Justiermarken freigelegt. Dieser zusätzliche Lithographie- und Ätzschritt ist jedoch aufwendig und teuer.

Aufgabe der vorliegenden Erfindung ist es deshalb, ein einfaches und kostengünstiges Verfahren zur Aufbringung von Justiermarken auf eine Halbleiterscheibe bereitzustellen, das sich insbesondere in Zusammenhang mit einer Strukturierung der Halbleiterscheibe mit Hilfe der Damascene-Technik einsetzen lässt.

Dies Aufgabe wird durch das im Anspruch 1 angegebene Verfahren gelöst. Bevorzugte Ausgestaltungen sind in den abhängigen Ansprüchen angegeben.

Gemäß der Erfindung wird zum Aufbringen von Justiermarken eine aus einem Nichtmetall bestehende kleinteilige Struktur in einer großflächigen Metallschicht auf wenigstens einem Bereich einer Halbleiterscheibe erzeugt. Anschließend wird dieser Bereich der Halbleiterscheibe mit der großflächigen Metallschicht durch chemisch-mechanisches Polieren planarisiert, wobei die Nichtmetall-Struktur in der Metallschicht und der chemisch-mechanische Polierprozess so aufeinander abgestimmt sind, dass die Nichtmetall-Struktur sich von der großflächigen Metallschicht abhebt.

Das erfindungsgemäße Ausbilden der Justiermarken ist an die Damascene-Technik angelehnt, wobei jedoch im Gegensatz zum herkömmlichen Justiermarkendesign eine aus einem Nichtmetall bestehende Struktur in einer großflächigen Metallschicht erzeugt wird. Durch diese Auslegung ist es möglich, gezielt zwei im Allgemeinen als negativ angesehene Effekte bei der Planarisierung mit Hilfe des chemisch-mechanischen Polierens zu nutzen.

Beim chemisch-mechanischen Polieren neigen nämlich großflächige Metallflächen, wenn sie eingeebnet werden sollen, dazu, zu stark abgetragen zu werden, d. h. zu einem Dishing-Verhalten. Dies führt dann beim erfindungsgemäßen Aufbau zu einem Herausstehen der in der Metallschicht vorgesehenen kleinteiligen Nichtmetallstruktur, so dass auf einer anschließend aufgebrachten, nicht transparenten Schicht eine als Justiermarken einsetzbare Topologie erzeugt wird.

Weiterhin kann zur Kontrastierung der Justiermarken auch der beim chemisch-mechanischen Polieren auftretende Effekt ausgenutzt werden, dass kleinteilige Nichtmetallstrukturen in einer großflächigen Metallschicht, wenn diese planarisiert werden sollen, ebenfalls dazu neigen, gegenüber der umliegenden Metallschicht zu stark abgetragen zu werden, d. h. zu erodieren, und damit Gräben in der Metallschicht zu bilden. Diese Grabenbildung der Justiermarken sorgt dann für eine Topologie auf der anschließend aufgebrachten nicht-transparenten Schicht, die sich zur Justierung eines Belichtungsgeräts eignet.

Je nach Auslegung des chemisch-mechanischen Poliervorgangs und dem Design der Metallfläche und der darin enthaltenen Nichtmetall-Struktur kann also ein Herausstehen der Nichtmetall-Struktur aufgrund eines Dishing-Verhaltens der Metallfläche oder eine Grabenbildung dieser Nichtmetall-Struktur in der Metallfläche aufgrund eines Erosionsverhaltens erreicht werden, was sich dann in einer Topologie auf der darüber angeordneten nicht-transparenten Schicht niederschlägt.

Gemäß einer bevorzugten Ausführungsform erfolgt die Justiermaskenaufbringung in Damascene-Technik, wobei die großflächige Metallschicht auf einer aus einem Dielektrikum bestehenden Schicht mit großflächigen Vertiefungen abgeschieden wird. Zwischen der Dielektrikumschicht und der Metallschicht ist dabei die weitere dünne Zwischenschicht zur Keimbildung für die Metalldeposition und als Diffusionsbarriere vorgesehen.

Der chemisch-mechanische Polierprozess erfolgt in zwei Stufen, wobei in einer ersten Stufe die Metallschicht abgetragen und auf der darunterliegenden Zwischenschicht gestoppt wird. Während dieses ersten Polierschrittes findet ein Dishing in den großen Metallflächen zwischen dem hervorstehenden Dielektrikumstrukturen statt, wobei auch die Zwischenschicht auf den hervorstehenden Dielektikumstrukturen teilweise abgetragen wird. In einem zweiten Polierschritt wird dann die Zwischenschicht auf diesen vorstehenden Dielektrikumstrukturen abgetragen, wobei der Poliervorgang im Dielektrikum gestoppt wird. Bei diesem zweiten Poliervorgang tritt ein starkes Überpolieren der Zwischenschicht und damit eine Erosion der darunterliegenden Dielektrikumschicht auf, so dass sich Gräben zwischen den großflächigen Metallschichten bilden, die dann nach Aufbringen einer nicht transparenten Schicht noch als Justiermarken erkennbar bleiben.

Dieser Verfahrensablauf ermöglicht es, insbesondere bei Verwendung von Kupfer als Metallschicht und Tantal/Tantalnitrid als Zwischenschicht, die Justiermarkenausbildung auch im Rahmen einer Kupfermetallisierung zur Ausbildung von Leiterbahnen einzusetzen.

Die Erfindung wird anhand der beigefügten Zeichnungen näher erläutert. Es zeigen:
- Figur 1: eine mögliche Ausführungsform des erfindungsgemäßen Verfahrens zum Aufbringen von Justiermarken im Rah- men einer Kupfermetallisierung mit Hilfe des Damascene-Verfahrens, wobei Figur 1A den Schichtenaufbau vor einem chemisch-mechanischen Polieren, Figur 1B nach einem ersten Polierschritt und Figur 1C nach einem zweiten Polierschritt zeigen; und
- Figur 2: eine Vorrichtung zum chemisch-mechanischen Polieren, wobei Figur 2A eine Draufsicht und Figur 2B eine Schnittansicht zeigen.

Integrierte Schaltungen werden auf den Halbleiterscheiben im Allgemeinen mit Hilfe lithographischer Verfahren erzeugt. Hierbei wird jede Strukturebene zunächst über eine Photomaske in einer dünnen strahlungsempfindlichen, auf der Halbleiterscheibe abgeschiedenen Schicht, meist einer organischen Resist-Schicht erzeugt und dann in einem speziellen Ätzverfahren in die darunterliegende Halbleiterschicht übertragen. Hierbei ist zu beachten, dass die übereinanderliegenden Strukturen der integrierten Schaltungen lagegenau zueinander angeordnet sind, um eine möglichst hohe Integrationsdichte zu erreichen. Entscheidend für eine lagegenaue Anordnung ist dabei, dass das Belichtungsgerät zur Überlagerung der Maskenstruktur mit einer bereits auf der Halbleiterscheibe vorhandenen Struktur exakt justiert wird.

Zum Ausrichten des Belichtungsgeräts werden Justiermarken auf der Halbleiterscheibe, vorzugsweise in einem 50 bis 100 µm breiten Kerfbereich 1, der später zum Zerlegen der Halbleiterscheiben in den einzelnen Chips genutzt wird, aufgebracht. Die Justiermarken müssen dabei so ausgelegt sein, dass sie eine Topologie in der auf den Justiermarken aufgebrachten Schicht erzeugen, die sich dann optisch erfassen lässt.

Im Folgenden wird die erfindungsgemäße Herstellung solcher Justiermarken im Rahmen einer Kupferstrukturierung, die in Damascene-Technik erfolgt, dargestellt.

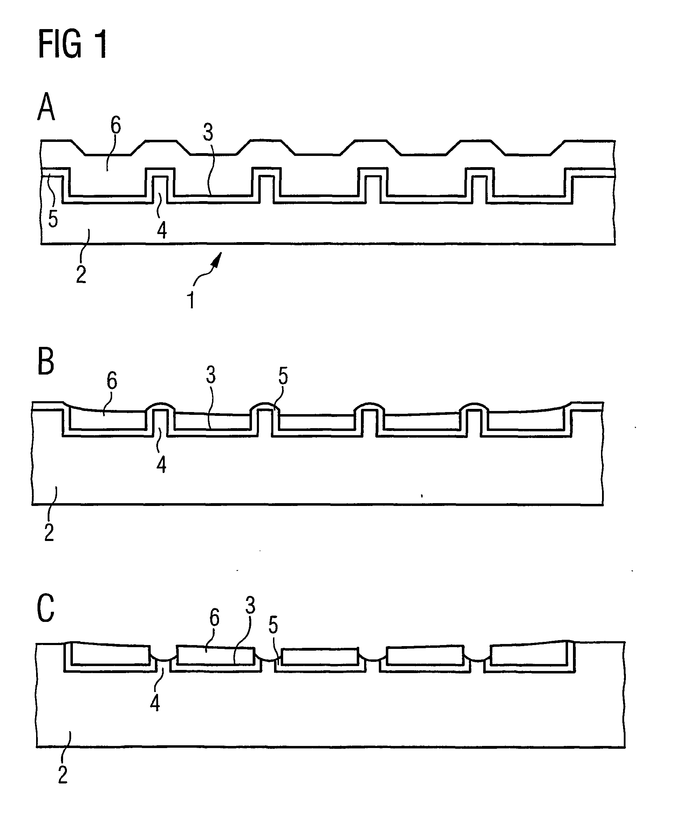

Zur Herstellung der Kupferverdrahtung in Damascene-Technik werden am Ort der Leiterbahnen möglichst anisotrop Vertiefungen in eine auf der Halbleiterscheibe aufgebrachte Dielektrikumschicht 2, die vorzugsweise aus Siliziumoxid besteht, geätzt. Gleichzeitig mit dieser Ätzung der Vertiefungen für die Leiterbahnen werden vorzugsweise im Kerfbereich 1 der Halbleiterscheibe weitere großflächige Vertiefungen 3 in die Dielektrikumschicht 2 geätzt, wobei, wie in Figur 1A gezeigt ist, zwischen diesen zusätzlichen großflächigen Vertiefungen 3 schmale Stege 4 in der Dielektrikumschicht verbleiben.

Im Bereich der Leiterbahnen wird im Damascene-Verfahren anschließend eine Zwischenschicht, vorzugsweise entweder durch Aufsputtern oder CVD-Abscheiden, aufgetragen. Diese Zwischenschicht gewährleistet einerseits ein sicheres Trennen des Kupfers vom Dielektrikum und vom darunterliegenden Halbleitersubstrat. Als Material für die Zwischenschicht wird dabei vorzugsweise eine Tantal/Tantalnitrid-Doppelschicht verwendet. Diese Zwischenschicht 5 wird, wie in Figur 1A gezeigt ist, auch im Bereich der zusätzlichen Vertiefungen 3 in der Dielektrikumschicht 2, die im Kerfbereich 1 der Halbleiterscheibe ausgeführt sind, aufgebracht. Anschließend wird über die gesamte Halbleiterscheibe, d. h. sowohl im Leiterbahnenbereich als auch im Kerfbereich 1 elektrolytisch oder chemisch stromlos Kupfer mit einer Dicke von ca. 1 µm abgeschieden. Hieraus ergibt sich dann ein Gesamtaufbau im Kerfbereich 1, wie er in Figur 1A gezeigt ist.

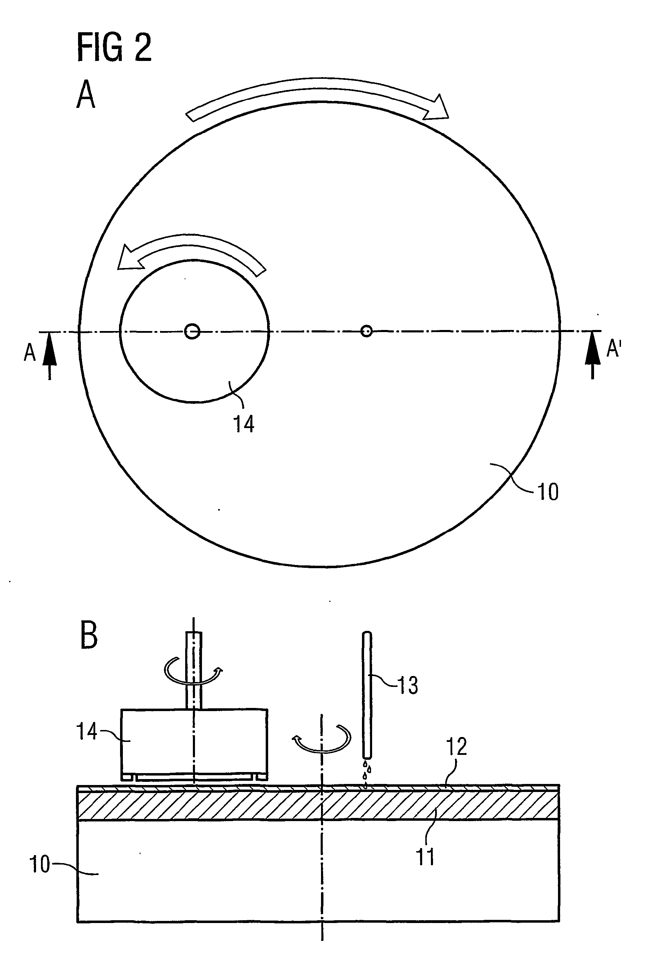

Zum Herausarbeiten der Justiermarken wird anschließend ein zweistufiger chemisch-mechanischer Polierprozess eingesetzt. Figur 2 zeigt schematisch eine Vorrichtung zum chemisch-mechanischen Polieren, wobei in Figur 2A eine Draufsicht und in Figur 2B ein Schnitt entlang der A-Linie dargestellt ist. Auf einem drehbar angeordneten Poliertisch 10 ist eine elastische perforierte Auflage 11 angeordnet, die ein Poliermittel 12 enthält. Das Poliermittel 12 wird der Auflage 11 über eine Poliermittelzuführung 13 zugeführt. Zum chemischen-mechanischen Polieren wird die zu bearbeitende Halbleiterscheibe von einem Scheibenträger 14 auf die Auflage 11 am Poliertisch 10 gedrückt. Dabei rotieren die Halbleiterscheibe und der Poliertisch 10. Das Poliermittel 12 ist so zusammengesetzt, dass es sowohl Polierkörner als auch aktiv-chemische Zusätze enthält. Die Polierkörner, die im Allgemeinen einen Durchmesser von 20 bis 50 nm aufweisen, dienen zum mechanischen Polieren der Oberfläche der Halbleiterscheibe. Die chemischen Zusätze im Poliermittel 12 werden auf das abzutragende Schichtmaterial abgestimmt.

Bei dem in Figur 1 dargestellten chemisch-mechanischen Polierprozess zur Herausarbeitung der Justiermarkenstruktur wird in einem ersten Polierprozess die Kupferschicht 6 abgetragen, wobei auf der aus Tantal/Tantalnitrid bestehenden Zwischenschicht 5 gestoppt wird. Der Kupfer-Polierprozess wird dabei mit einem auf Aluminiumoxid basierenden Poliermittel durchgeführt. Als Poliertischauflage wird vorzugsweise Pan W (Freudenberg) verwendet. Dieser erste Kupfer-Polierschritt auf dem Kerfbereich 1 wird vorzugsweise gleichzeitig mit dem Abpolieren der Kupferschicht über den für die Leiterbahnen vorgesehenen Vertiefungen ausgeführt.

Wie Figur 1B zeigt, kommt es beim Kupfer-Polieren im Kerfbereich 1 zu einem Dishing-Verhalten der Kupferflächen, so dass die Stege 4 in der Dielektrikumschicht 2 aus der Metallfläche 6 hervortreten. Gleichzeitig mit dem Dishing des Kupfers während des Polierprozesses kommt es jedoch, wie Figur 1B weiter zeigt, auch noch zu einem teilweisen Abtragen der Zwischenschicht 5 im Bereich der Stege 4 in der Dielektrikumschicht 2.

Nach dem Kupfer-Polierschritt wird ein zweiter Tantal-Polierschritt ausgeführt, bei dem die Zwischenschicht 5 auf den Stegen 4 in der Dielektrikumschicht 2 abgetragen wird. Zum Tantal-Polieren wird dabei vorzugsweise ein Poliermittel auf der Basis von kolloidalen Siliziumoxid verwendet. Als Poliertischauflage wird vorzugsweise Politex embossed (Rodel) eingesetzt. In diesem Tantal-Polierschritt findet, wie Figur 1C zeigt, im Bereich der Stege 4 ein sehr starkes Abtragen der Zwischenschicht 5 statt, bei der auch Material aus der darunterliegenden Dielektrikumschicht 2 entfernt wird. Dieses Überpolieren, das zu einer Erosion der unter der Zwischenschicht liegenden Dielektrikumschicht 2 führt, ist insbesondere auch darauf zurückzuführen, dass im Kupfer-Polierschritt bereits ein großer Teil der Zwischenschicht 5 entfernt wurde. Als Folge des Tantal-Polierschrittes kommt es, wie Figur 1C zeigt, zu einer Grabenbildung im Bereich der Stege 4 in der Dielektrikumschicht 2 zwischen den Metallflächen 6. Diese Grabenbildung sorgt dann dafür, dass sich eine Topologie der Justiermarken auf einer anschließend aufgebrachten Schicht abzeichnet, die sich zur Justierung eines Belichtungsgeräts zur Übertragung einer Maske eignet.

Das erfindungsgemäße Verfahren zum Ausbilden der Justiermarken lehnt sich im Wesentlichen an die Damascene-Technik an, wobei jedoch eine aus einem Nichtmetall bestehende kleinteilige Struktur in einer großflächigen Metallschicht erzeugt wird. Durch diesen Schichtenaufbau ist es möglich, mit Hilfe des chemisch-mechanischen Polierens durch Nutzen der an sich negativen Effekte des Dishings großer Metallflächen bzw. des Erodierens kleinteiliger Strukturen beim Poliervorgang die kleinteilige Struktur aus der großen Metallfläche herauszuarbeiten.

Bei der oben dargestellten Ausführungsform wird ein zweistufiger Polierprozess eingesetzt, der sich insbesondere zur Justiermarkenausbildung in einer Kupfer-Metallisierungsebene eignet.

Statt der Verwendung von Kupfer als Metall und einer Zwischenschicht aus Tantal/Tantalnitrid besteht jedoch auch die Möglichkeit, ein anderes Metall bzw. ein anderes Material für die Zwischenschicht einzusetzen.

Die in der vorstehenden Beschreibung, den Zeichnungen und den Ansprüchen offenbarten Merkmale der Erfindung können sowohl einzeln als auch in beliebiger Kombination für die Verwirklichung der Erfindung in ihren verschiedenen Ausgestaltungen von Bedeutung sein.

### Bezugszeichenliste

- 1: Kerfbereich
- 2: Dielektrikumschicht
- 3: Vertiefungen
- 4: Stege
- 5: Zwischenschicht
- 6: Metallschicht (Kupfer)
- 10: Poliertisch
- 11: Auflage
- 12: Poliermittel
- 13: Poliermittelzuführung
- 14: Scheibenträger

## Patentansprüche

1. Verfahren zum Erzeugen von Justiermarken auf einer Halbleiterscheibe mit den Schritten:
Herstellen einer aus einem Nichtmetall bestehenden kleinteiligen Struktur (2, 3, 4) in einer großflächigen Metallschicht (6) in wenigstens einem Bereich der Halbleiterscheibe durch Ausbilden von Vertiefungen (3) in einem Oberflächenbereich der Halbleiterscheibe, wobei sich nichtmetallische Stege (4) zwischen den Vertiefungen (3) bilden, und anschließendes Abscheiden einer Zwischenschicht (5) und der Metallschicht (6) über den gesamten Oberflächenbereich; und
Bearbeiten des Bereiches der Halbleiterscheibe mit der großflächigen Metallschicht (6) durch chemisch-mechanisches Polieren in zwei Stufen, wobei in der ersten Stufe die Metallschicht (6) abgetragen wird, bis durch Überpolieren der Metallflächen (6) die Stege (4) vorstehen, wobei die Zwischenschicht (5) auf den vorstehenden Stegen (4) nur teilweise mit abgetragen wird, und in der zweiten Stufe die Zwischenschicht (5) abgetragen wird, und wobei durch ein starkes Überpolieren der Zwischenschicht (5) eine Erosion der darunter liegenden Stege (4) auftritt, so dass sich Gräben als Justiermarken zwischen den Metallflächen (6) ergeben.

2. Verfahren gemäß Anspruch 1, wobei auf der Halbleiteroberfläche eine Dielektrikumschicht (2), in der die Vertiefungen (3) und Stege (4) ausgeführt werden, ausgebildet ist.

3. Verfahren gemäß Anspruch 1 oder 2, wobei die Metallschicht (6) aus Kupfer besteht.

4. Verfahren gemäß einem der Ansprüche 1 bis 3, wobei die Zwischenschicht (5) eine Tantal/Tantalnitrid-Doppelschicht ist.

5. Verfahren gemäß einem der Ansprüche 1 bis 4, wobei die Justiermarken im Kerfbereich (1) der Halbleiterscheibe aufgebracht werden.

## Claims

1. A method for forming alignment markers on a semiconductor wafer comprising the steps of:
forming a small piece structure (2, 3, 4) of a non-metal in a large area metal layer (6) in at least one region of the semiconductor wafer by providing recesses (3) in a surface area of the semiconductor wafer, whereby non metallic bars (4) are formed between the recesses (3), and subsequently depositing an intermediate layer (5) and the metal layer (6) over the entire surface area; and
treating the region of the semiconductor wafer comprising the large area metal layer (6) by chemical mechanical polishing in two steps, wherein in the first step the metal layer (6) is ablated until the bars (4) are exposed by polishing the metal areas (6), wherein the intermediate layer (5) is only partially ablated on the exposed bars (4), and wherein in the second step the intermediate layer (5) is ablated, and wherein by a strong polishing of the intermediate layer (5) an erosion of the underlying bars (4) is achieved such that trenches are formed as alignment markers between the metal areas (6).

2. The method of claim 1, wherein a dielectric layer (2) is formed on the semiconductor surface, in which the recesses (3) and the bars (4) are provided.

3. The method of claim 1 or 2, wherein the metal layer (6) is made of copper.

4. The method according to one of claims 1 to 3, wherein the intermediate layer (5) is a tantalum/tantalum nitride double layer.

5. The method according to one of claims 1 to 4, wherein the alignment markers are formed in a kerf region (1) of the semiconductor wafer.

## Revendications

1. Procédé de production de repères de réglage sur une plaquette semi-conductrice, comprenant les étapes suivantes :
- fabrication d'une structure en petites parties constituée d'un non-métal (2, 3, 4) dans une couche métallique de grande surface (6) dans au moins une zone de la plaquette semi-conductrice en formant des renfoncements (3) dans une zone de surface de la plaquette semi-conductrice, des entretoises non métalliques (4) se formant entre les renfoncements (3), et séparation ultérieure d'une couche intermédiaire (5) et de la couche métallique (6) sur la totalité de la zone de surface ; et
- traitement de la zone de la plaquette semi-conductrice avec la couche métallique de grande surface (6) par polissage mécano-chimique en deux étapes, la couche métallique (6) étant décapée dans la première étape jusqu'à ce que les entretoises (4) saillent par surpolissage des surfaces métalliques (6), la couche intermédiaire (5) sur les entretoises saillantes (4) n'étant décapée conjointement que partiellement, et la couche intermédiaire (5) étant décapée dans la seconde étape, et une érosion des entretoises (4) situées en dessous apparaissant, due à un fort surpolissage de la couche intermédiaire (5), de telle sorte qu'il se produit des rigoles en tant que repères de réglage entre les surfaces métalliques (6).

2. Procédé selon la revendication 1, une couche diélectrique (2), dans laquelle sont réalisés les renfoncements (3) et les entretoises (4), étant formée sur la surface semi-conductrice.

3. Procédé selon la revendication 1 ou 2, la couche métallique (6) étant constituée de cuivre.

4. Procédé selon une des revendications 1 à 3, la couche intermédiaire (5) étant une double couche de tantale/nitrure de tantale.

5. Procédé selon une des revendications 1 à 4, les repères de réglage étant appliqués dans la zone d'entaille (1) de la plaquette semi-conductrice.
